# EUROPEAN PATENT SPECIFICATION

(11) **EP 0 433 467 B1**
(45) Date of publication and mention of the grant of the patent: **16.08.1995**
(21) Application number: 89123346.2
(22) Date of filing: 18.12.1989
(51) Int. Cl.: H01L 21/027, G03F 1/14

(54) **Fabrication of complementary patterns for exposing semiconductor chips with self-supporting masks**
Verfahren zur Herstellung von komplementären Mustern zur Exposition von Halbleiterkörpern mit selbsttragenden Masken
Fabrication de motifs structurés complémentaires pour l'exposition de puces semi-conductrices avec des masques à auto-support

(43) Date of publication of application: 26.06.1991
(73) Proprietor: International Business Machines Corporation, Armonk, N.Y. 10504 (US)
(72) Inventor: Engelke, Helmut, Dr. Dipl.-Phys., D-7031 Altdorf (DE)
(74) Representative: Schäfer, Wolfgang, Dipl.-Ing.

(56) References cited:
- IBM JOURNAL OF RESEARCH AND DEVELOPMENT. vol. 26, no. 5, September 1982, NEW YORK US pages 568 - 579; H. BOHLEN ET AL.: "ELECTRON-BEAM PROXIMITY PRINTING- A NEW HIGH-SPEED LITHOGRAPHY METHOD FOR SUBMICRON STUCTURES."
- ELECTRONIC ENGINEERING. vol. 58, no. 719, November 1986, LONDON GB page 29 "HIGH SPEED EBL AT CAMBRIDGE."
- MICROELECTRONIC ENGINEERING. vol. 3, no. 1-4, 1985, AMSTERDAM NL pages 511 - 518; R.D.J. VERHAAR ET AL.: "E- BEAM LITHOGRAPHY FOR SUB-MICRON MOS-DEVICES. "

## Description

This invention relates to a method of splitting a layout of an electrical circuit into two complementary patterns, said patterns being used in connection with self-supporting masks for exposing semiconductor chips.

For the fabrication of semiconductor chips with an increasing number of electrical elements it is necessary that the geometry of the elements becomes smaller and smaller. For example, a 64 megabit storage chip requires a line-width of about 0.5 micrometer. To be able to meet these demands, lithographic techniques have been developed using x-rays, electron beams and ion beams.

As an example, IBM Journal of Research and Development, Volume 26, Number 5, published in September 1982, p.568-579, describes an electron-beam proximity printer which shadow-projects patterns of self-supporting transmission masks onto chips.

Said self-supporting transmission masks have physical holes at transparent areas, with the consequence that it is not possible to fabricate for example a ring-shaped structure with only one mask as this structure cannot support its center. This so-called mask stencil problem is solved by exposing the chip with two complementary masks as described for example in the above mentioned paper and in IBM Technical Report, TR 28.120 of February 1981 which was only used internally.

The solution is that the layout of the semiconductor chip is split into sections using a computer program and avoiding ring-shaped structures, long slits, free-standing bars ect. These sections are shared between said two masks and the chip is then exposed with these two masks in succession.

By using the described method it became obvious that said splitting into sections was too complex and time consuming for doing it manually, and often said two complementary masks could not fulfil the requirements of practical use, for example with respect to the mechanical stability of the masks.

For that reason, it is an object of the invention to create a method for splitting a layout of an electrical circuit into two complementary patterns, which method can be carried out automatically and considers the requirements of practical use of said masks.

This object is solved by a method according to claim 1.

First of all said method determines all corners of the layout which extend into a hole representing area of said masks. Then a stability criterion is carried out for these corners, with the consequence that only instable corners are used for cutting said hole representing area into sections. After that, these sections are distributed onto said two masks alternatively.

This method can be carried out automatically, for example by a computer, by executing one step after the other. Furthermore, this method considers the requirement that the complementary masks have to be mechanically stable. This is a very important requirement for the practical use of these masks. Furthermore, the method does not use all corners for cutting the hole representing area into sections but only those corners which are instable. This has the effect that when using a computer the computing time and especially the required storage is reduced essentially.

Claims 2 to 4 provide an advantageous way of how to carry out said stability criterion for any kind of corner extending in a hole representing area.

Claim 5 provides an advantageous way of how to cut said hole representing areas into sections without establishing crossed cutting lines which have disadvantages in practical use.

Claim 6 provides an advantageous way to divide large sections which also have disadvantages in practical use into several sub-sections.

Claims 7 and 8 provide an overlap for each of said cutting lines which is advantageous in connection with the positioning of the masks.

Claim 9 provides an advantageous way of establishing the two complementary patterns.

The foregoing aspects and other features of the invention are explained in the following description taken in connection with the accompanying drawings wherein
Fig. 1 is a top view of a conventional mask with a polygonal layout,
Figs. 2a to 2c show the steps in which the layout of Fig. 1 is divided into sections,
Figs. 3a and 3b are top views of two complementary masks which incorporate the sections of Fig. 2c and which correspond to the conventional mask of Fig. 1,
Fig. 4 is a top view of six different corners of a mask which extend into a hole representing area,
Fig. 5 is a diagram showing the dependency of the stability limit value T and the short cut length L,
Figs. 6a and 6b show the steps in which the layout of Fig. 1 is divided into sections which are different from those of Fig. 2c,
Figs. 7a and 7b are top views of two complementary masks which incorporate the sections of Fig. 6b and which correspond to the conventional mask of Fig. 1,
Fig. 8 is a top view of a conventional mask with a polygonal layout including a kind of tongue,
Figs. 9a to 9c show the steps in which the layout of Fig. 8 is divided into sections,
Figs. 10a and 10b are top views of two complementary masks which incorporate the sections of Fig. 9c and which correspond to the conventional mask of Fig. 8,
Fig. 11 is a top view of a conventional mask with a polygonal layout including a kind of a meander,
Figs. 12a to 12d show the steps in which the layout of Fig. 11 is divided into sections,
Figs. 13a and 13b are top views of two complementary masks which incorporate the sections of Fig. 12b and which correspond to the conventional mask of Fig. 11,
Fig. 14 is a top view of a conventional mask with a polygonal layout including a non-supported inner area,
Figs. 15a and 15b show the steps in which the layout of Fig. 14 is examined with regard to the division of the layout into sections,
Figs. 16a and 16b are top views of two complementary masks which incorporate the sections mentioned in connection with Fig. 15b and which correspond to the conventional mask of Fig. 14,
Fig. 17 is a top view of a conventional mask with a polygonal layout including a large hole representing area,
Figs. 18a and 18b are top views of two complementary masks which correspond to the conventional mask of Fig. 17 and which have a large section,
Fig. 19 and
   Fig. 21 show the step in which the layout of Fig. 17 is divided into small sections,

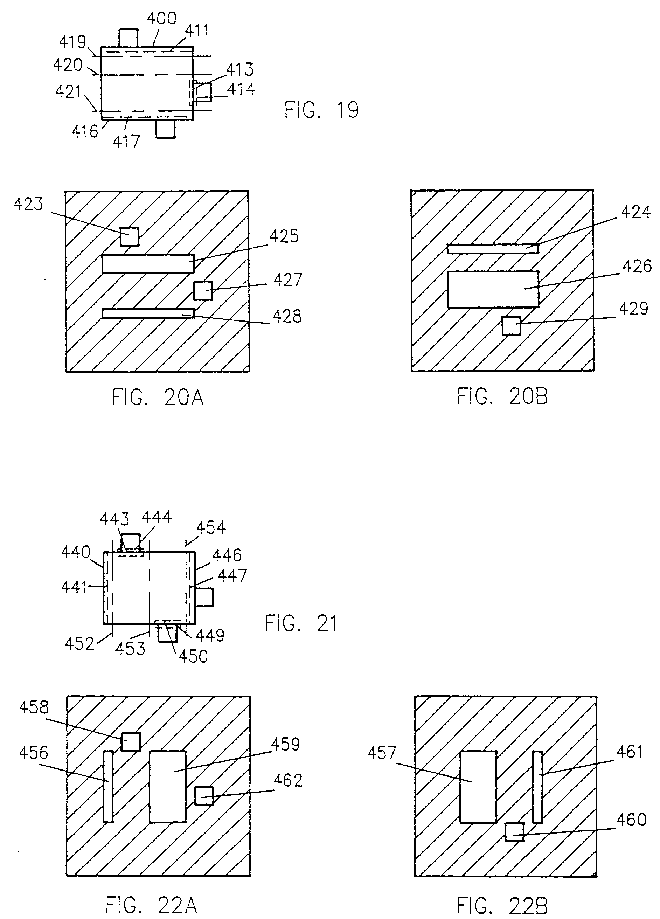

Figs. 20a and 20b and

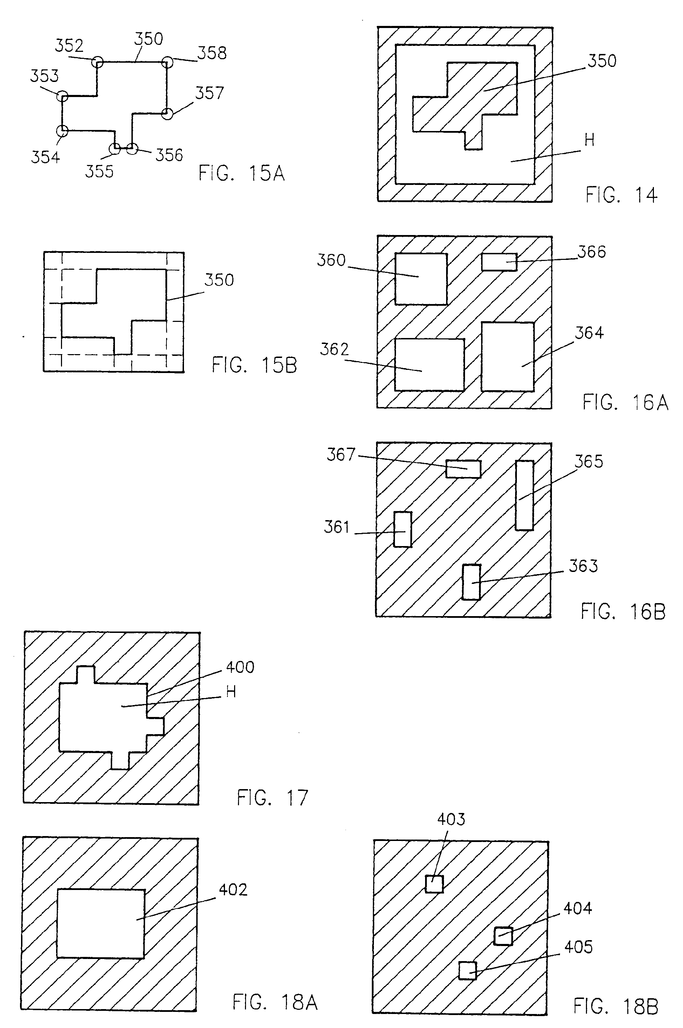

   Figs. 22a and 22b are top views of two complementary masks which incorporate the small sections of Fig. 19 and Fig. 21, which correspond to the conventional mask of Fig. 17 and which have no large section,
Figs. 23a and 23b,

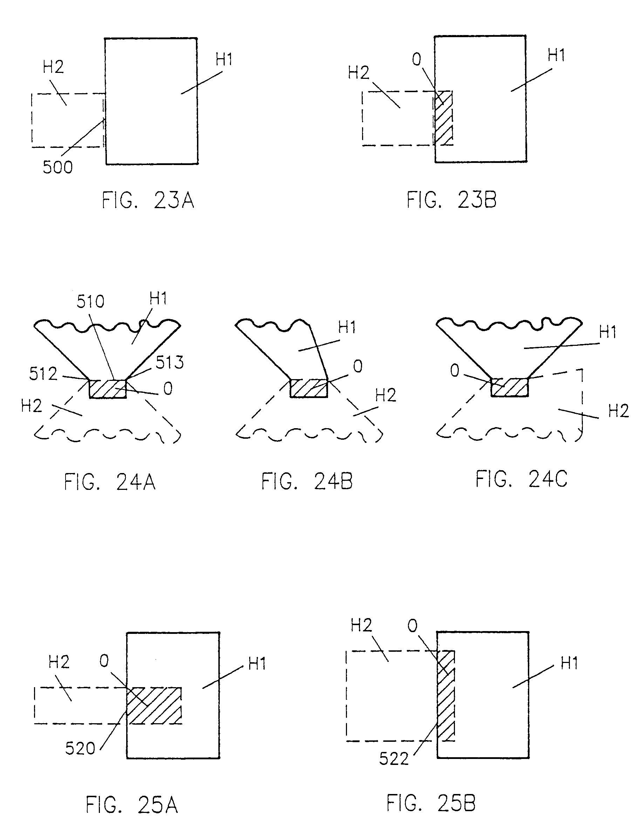

   Figs. 24a, 24b, 24c and
   Figs. 25a and 25b show different ways of overlapping sections of two complementary masks.

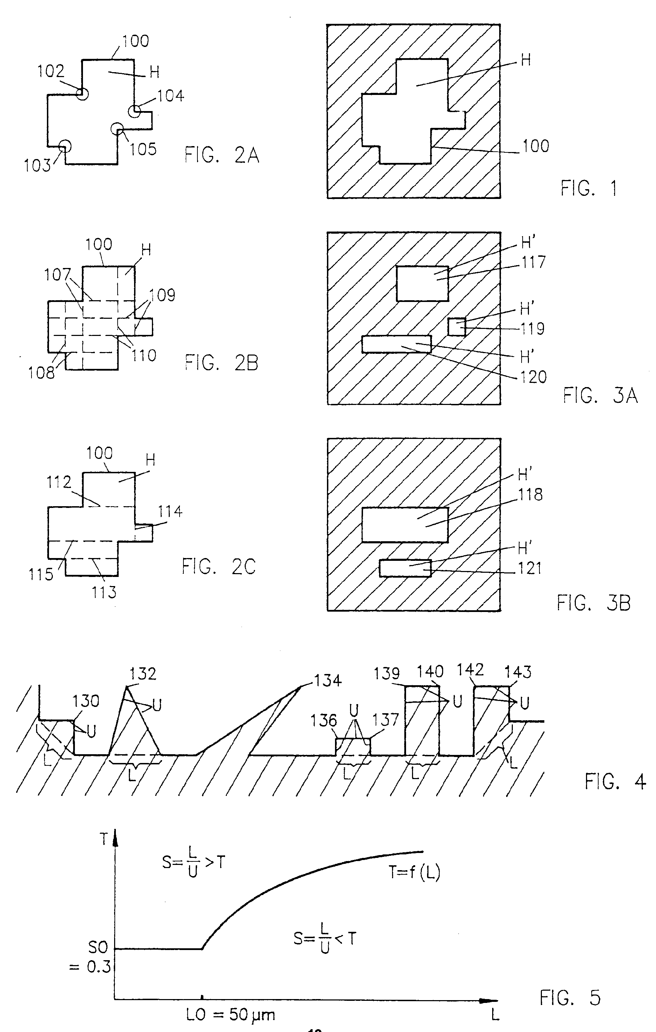

Fig. 1 shows a conventional mask for exposing semiconductor chips. "Conventional" means that it was not fabricated with the help of the splitting method according to the invention. In contrast to that, Figs. 3a and 3b show two masks which were fabricated with the help of said splitting method. Both masks of Figs. 3a and 3b taken together "correspond" to the mask of Fig. 1, that means, that the exposure of a chip with the masks of Figs. 3a and 3b in succession has the same result as the exposure of a chip with the mask of Fig. 1.

The mask shown in Fig. 1 as well as the masks shown in Figs. 3a and 3b are made of silicon, for example with a thickness of about 3 micrometer. The mask shown in Fig. 1 has a layout which comprises a polygon 100 and which encircles a physical hole marked by an H. The hole representing area H encircled by the polygon 100 of Fig. 1 is split into several hole representing sections in the masks of Figs. 3a and 3b. The splitting method will be described with the help of Figs. 2a to 2c.

Fig. 2a shows the polygon 100. It consists of a number of corners and edges. Some of said corners extend into said hole representing area which is marked by said H in Fig. 1. These corners are called inside corners and have the numerals 102, 103, 104 and 105 in Fig. 2a. All other corners of the polygon 100 which do not extend into said hole representing area H are called outside corners.

In a first step of said splitting method all inside corners 102, 103, 104 and 105 of said polygon 100 of Fig. 2a are determined. This step is shown in Fig. 2a.

In a next step which is shown in Fig. 2b pairs of cutting lines 107, 108, 109 and 110 are planned which run from said inside corners 102, 103, 104 and 105, respectively, to one of said edges. Each of said corners 102, 103, 104 and 105 is provided with two cutting lines which are rectangular. All these cutting lines 107, 108, 109 and 110 have points of intersection in the hole representing area H of the polygon 100.

Then possible sets of cutting lines are assembled which incorporate one cutting line of each of said pairs of cutting lines 107, 108, 109 and 110, respectively, and which do not intersect. Out of these sets of cutting lines that one with the shortest length of its cutting lines summed up is selected. In Fig. 2c the set with said shortest length is shown incorporating cutting lines which have the numerals 112, 113, 114 and 115.

With the help of the cutting lines 112, 113, 114 and 115 the hole representing area H is partitioned into several sections. In a next step these sections are distributed to said two masks shown in Figs. 3a and 3b where said sections have the numerals 117, 118, 119, 120 and 121. Section 117 is established by a part of the polygon 100 and said cutting line 112, section 118 by a part of the polygon 100, too, and by the cutting lines 112, 114 and 115, etc. The sections 117, 118, 119, 120 and 121 are distributed alternatively to said two masks of Figs. 3a and 3b, that means that adjacent sections are distributed to different masks, e.g. section 117 to the mask shown in Fig. 3a and section 118 to the mask shown in Fig. 3b.

All sections 117, 118, 119, 120 and 121 of the masks shown in Figs. 3a and 3b are marked by an H′. This emphasizes that all said sections represent physical holes in said two masks. Adding up all these hole representing areas H′ in Figs. 3a and 3b results in the hole representing area H of Fig. 1. For that reason, the two masks shown in Figs. 3a and 3b correspond to the mask shown in Fig. 1.

For a better understanding, the mechanical stability of the masks was not considered in connection with the foregoing example. This will be done now with respect to Figs. 4 to 7.

In Fig. 4 several examples of possible inside corners 130, 132, 134, 136, 137, 139, 140, 142 and 143 of a mask is shown. As all these inside corners extend into the region of a physical hole, each of them has a mechanical stability. This means that the part which incorporates said inside corner remains more or less plane with the rest of the mask. Generally, the more an inside corner of a mask extends into a hole representing area, the less its surrounding part is in the same plane as the rest of the mask.

According to the invention, a stability value S is assigned to any of said inside corners. This stability value S is the quotient of a short cut length L and a perimeter U:
S = L / U.

As shown in Fig. 4, the short cut length L is the length between the next adjacent outside corners on both sides of an inside corner. This is shown in Fig. 4 in connection with the inside corners 130 and 132 with broken lines. In cases, when the inside corner extends in a diagonal manner into the hole representing area, the inside corner has no mechanical stability, independent of the stabilty value S. Measurement of the short cut length L and the perimeter U is not necessary. This case is shown in Fig. 4 in connection with the inside corner 134. When there are two or more inside corners in a row, the short cut length L is measured between the next adjacent outside corners on both sides of said row. This is shown in Fig. 4 in connection with the inside corners 136, 137, 139, 140 and 142, 143 in broken lines.

As shown in Fig. 4, too, the perimeter U is the length from the next adjacent outside corner on one side of an inside corner to the next adjacent outside corner on the other side of said inside corner. The difference between the short cut length L and the perimeter U is that the short cut length L is the shortest length between said two next adjacent outside corners and is independent of any edges, whereas the perimeter U is the longest length along edges between said two outside corners.

In connection with the inside corners 130, 132 and 134 the perimeter U consists of the length of two edges as shown in Fig. 4. In connection with the inside corners 136, 137, 139, 140 and 142, 143, where always two inside corners are arranged in a row, the perimeter U consists of the length of three edges, respectively, as shown in Fig. 4, too.

In Fig. 5 a graph of a stability limit function T is shown. This stability limit function T depends on the short cut length L: T = f(L). To one direction of the cartesian coordinates shown in Fig. 5 said stability limit value T is assigned, to the other direction said short cut length L. According to the graph, the stability limit function T is constant and has the value S0 = 0.3 for short cut lengths 0 < L < L0 with L0 = 50 micrometer. The values S0 = 0.3 and L0 = 50 micrometer are empirical values which have proved advantageous. For short cut lengths greater than L0 = 50 micrometer the stability limit function T is increasing.

All inside corners with a stability value S which is less than said stability limit function T have no mechanical stability, whereas all inside corners with a stability value S which is greater than said stability limit function T are mechanically stable. This means that all stability values S which are below said function T (S<T) belong to instable inside corners and all stability values S which are above said function T (S>T) belong to stable inside corners.

According to the invention, not all inside corners are taken for planning and creating cutting lines, but only those inside corners which are instable. All inside corners which have a mechanical stability are not taken into consideration. This is determined by comparing the stability value S of said inside corner with the stability limit function T.

If for example the inside corners 103 and 104 of the mask shown in Figs. 1 and 2a would be stable, only the other instable inside corners 102 and 105 would be taken for creating cutting lines.

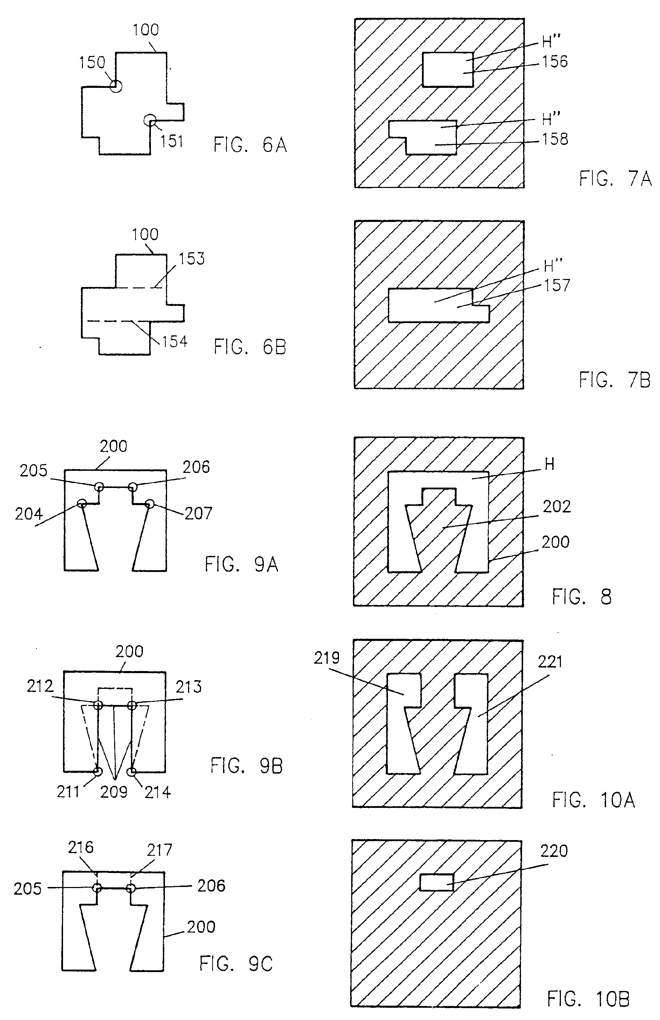

This is shown in Fig. 6a where said other instable inside corners have the numerals 150 and 151. With these inside corners 150 and 151 the same steps are carried out as already described in connection with Figs. 2a, 2b and 2c. First, each of said inside corners 150 and 151 is provided with a pair of cutting lines, then sets of cutting lines are planned which do not intersect and finally that set of cutting lines is selected which has the shortest length of all cutting lines summed up. This result of said selected set of cutting lines is shown in Fig. 6b where said cutting lines have the numerals 153 and 154.

After that, the sections which are created by said cutting lines 153 and 154 are distributed alternatively onto two masks. These two masks are shown in Fig. 7a and 7b where said sections have the numerals 156, 157 and 158. Again, these sections 156, 157 and 158 represent physical holes in said masks which are marked with an H˝. Adding up these hole representing areas H˝ shown in Fig. 7a and 7b results in the hole representing area H shown in Fig. 1. For that reason, the two masks shown in Fig. 7a and 7b correspond to the mask shown in Fig. 1.

With respect to Figs. 8 to 13 another additional step in connection with the examination of the mechanical stability of the inside corners of a mask will now be described.

Figure 8 shows a conventional mask with a polygon 200 which encircles a hole representing area H. Due to the form of the polygon 200 a tongue 202 extends into the hole representing area H. This tongue 202 has no mechanical stability, that means that the tongue 202 is not plane with the rest of the mask shown in Fig. 8.

As already described, for splitting said conventional mask into two corresponding masks in a first step all inside corners are determined. These inside corners have the numerals 204, 205, 206 and 207 in Fig. 9a. Then the stability value S of all said inside corners 204, 205, 206 and 207 is compared with the stability limit function T, respectively. If the stability value S would be greater than the stability limit function T, the corresponding inside corner would be mechanically stable, in the opposite case the inside corner would be instable.

For the purpose of explanation, it is assumed that all inside corners 204, 205, 206 and 207 shown in Fig. 9a are stable.

According to the method described in connection especially with Figs. 6a and 6b, only instable inside corners are provided with cutting lines. This would have the consequence, that in the assumed case of Fig. 9a where all inside corners are stable no cutting lines would be created. As a result, the instable tongue 202 would not be eliminated.

According to the invention, this is overcome in additional steps with the help of hull polygons.

In said additional step all outside corners are determined which are adjacent to the inside corners of the polygon. In Fig. 9b these outside corners have the numerals 211, 212, 213 and 214. These outside corners are then interconnected with lines which as a whole constitute the hull polygon. In Fig. 9b the lines which represent the hull polygon have the numeral 209. Now, that part of the polygon 200 which forms the tongue 202 is replaced by the hull polygon 209. This is shown in Fig. 9b with the help of a broken line.

Subsequently, the polygon 200 together with the hull polygon 209 is examined according to the method as already described. During this examination, the former outside corners 212 and 213 are now inside corners because they extend from the hull polygon into the hole representing area. This has the effect that the stability value S of these former outside corners 212 and 213 is compared with the stability limit function T and according to the result additional cutting lines are created.

In the present case it is assumed that said former outside corners 212 and 213 are instable.

Now all adjacent inside corners of these instable former outside corners are determined. In the present case, these are the inside corners 204, 205, 206 and 207. Out of these inside corners those are selected which have the lowest stability value S. In the present case it is assumed that the inside corners 205 and 206 have a lower stability value S than the inside corners 204 and 207. After that, cutting lines are planned and created in connection with said selected inside corners 205 and 206 according to the method already described. These cutting lines have the numerals 216 and 217 in Fig. 9c. At the end, as already described, the sections which are created by the cutting lines 216 and 217 are distributed alternatively onto said two masks.

These two masks are shown in Fig. 10a and 10b where said sections have the numerals 219, 220 and 221. Said sections represent physical holes in said masks. Adding up these holes in said masks of Figs. 10a and 10b results in the hole representing area of the corresponding mask shown in Fig. 8.

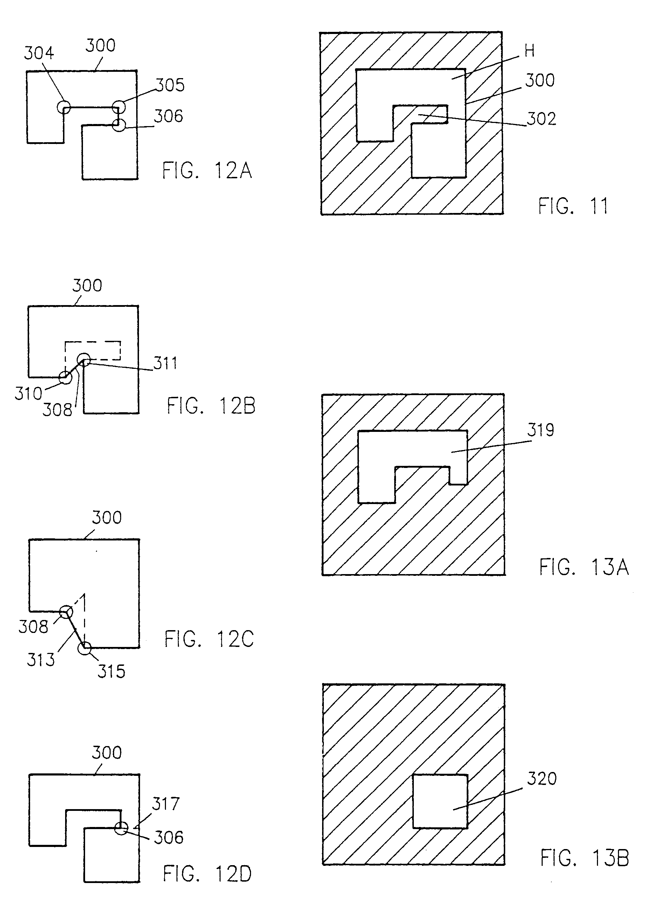

Fig. 11 shows a conventional mask with a polygon 300 which encircles a hole representing area H. Due to the form of the polygon 300 a meander is established with an inner part 302 which extends into the hole representing area H. This inner part 302 has no mechanical stability, that means that it is not plane with the rest of the mask shown in Fig. 11.

As already described, for splitting said conventional mask into two corresponding masks in a first step all inside corners are determined. These inside corners form a row and have the numerals 304, 305 and 306 in Fig. 12a. Then the stability value S of said row of inside corners 304, 305 and 306 is compared with the stability limit function T. If the stability value S would be greater than the stability limit function T, then the row of inside corners would be mechanically stable, in the opposite case said row would be instable.

For the purpose of explanation it is assumed that said row of inside corners 304, 305 and 306 shown in Fig. 12a is instable.

According to the method as described, this has the consequence that all these instable inside corners 304, 305 and 306 are provided with cutting lines without checking if this is necessary for all said inside corners with respect to their stability value, respectively. It has been found that often in cases with a row of inside corners it is not necessary to provide each of said inside corners of said row with a cutting line. Sometimes only one or two cutting lines are sufficient.

According to the invention said additional steps concerning said hull polygon which are described in connection especially with Figs. 9a, 9b and 9c are carried out.

In a first step the hull polygon is established by connecting all outside corners which are adjacent to said inside corners. In the present case, the inside corners 304, 305 and 306 are forming a row with the consequence that there are only two adjacent outside corners. These outside corners have the numerals 310 and 311 in Fig. 12b. The line which connects said outside corners 310 and 311 and which establishes the hull polygon has the numeral 308 in Fig. 12b. The broken line in Fig. 12b emphasizes that the inner part 302 of the polygon 300 which incorporates said row of inside corners and which is replaced by said hull polygon 308 is now disregarded.

In the next step the polygon 300 together with said hull polygon 308 is examined with respect to the mechanical stability of its inside corners. During this procedure the former outside corner 311 is now an inside corner with the consequence that its stability value S is compared with the stability limit function T.

For the purpose of this example, it is assumed that the former outside corner 311 is instable.

Due to this instability, the step of forming a hull polygon is repeated again. This is shown in Fig. 12c. There, the outside corners which are adjacent to said former outside corner 311 which is now an inside corner are determined. These outside corners have the numerals 308 and 315 in Fig. 12c. Said two outside corners 308 and 315 are connected with a line which forms the new hull polygon and which has the numeral 313 in Fig. 12c.

Again, with the help of the broken line in Fig. 12c it is shown that the former hull polygon is now disregarded. This part is replaced by the new hull polygon 313.

In the next step, the new hull polygon is examined with respect to its stability. This is done in the way already described above and it is assumed that the former outside corner 308 which is now an inside corner is stable, with the consequence that the step of forming a new hull polygon is not repeated again. Then that instable inside corner which was the last to be determined is selected. In the present case this is the former outside corner 311 which was determined to be instable in connection with the first hull polygon as shown in Fig. 12b.

Now, as already described in connection with Fig. 9c that inside corner is determined which is adjacent to said instable former outside corner 311. In the present case, this is the inside corner 306. After that, a cutting line is planned and created in connection with said inside corner 306 according to the method already described. This cutting line has the numeral 317 in Fig. 12d. Finally, as already described, the sections which are created by the cutting line 317 are distributed alternatively onto said two masks.

These two masks are shown in Fig. 13a and 13b where said sections have the numerals 319 and 320 representing physical holes in said masks, respectively. Adding up these holes in said masks of Figs. 13a and 13b results in the hole representing area of the corresponding mask shown in Fig. 11.

In connection with Figs. 14 to 16 the splitting of a so-called inside polygon is described.

Figure 14 shows a conventional mask with an inside polygon 350. This inside polygon encircles a central part which is separated from the rest of the mask by a physical hole H and which has for that reason no connection to said rest of said mask. As a result, said central part is not supported by the mask.

In Fig. 15a said inside polygon 350 is shown again. In a first step all inside corners which extend into the hole representing area H are determined. Said inside corners have the numerals 352, 353, 354, 355, 356, 357 and 358 in Fig. 15a. As already described especially in connection with Figs. 2a, 2b and 2c pairs of cutting lines are created in a next step and an optimal set of cutting lines is selected. This is shown in Fig. 15b. Said optimal set of cutting lines establishes sections which are then distributed alternatively onto two masks.

These two masks are shown in Fig. 16a and 16b where said sections have the numerals 360, 361, 362, 363, 364, 365, 366 and 367. All these sections represent physical holes in said masks with the result that the addition of these holes corresponds to the hole representing area H in the mask of Fig. 14.

Especially in connection with said so-called inside polygon, but with any other polygon too, it is possible that the sections which are created with the help of the method described cannot be distributed alternatively to said two masks because the number of all sections or the number of sections surrounding a hole is odd with the consequence that two adjacent sections cannot be distributed to different masks.

According to the invention, this is detected by an additional step which determines if the number of all sections or the number of sections surrounding a hole is divisible by two. If said number is even, it is possible to distribute said sections to said two masks alternatively, but if said number is odd, one additional cutting line is created. This cutting line can be added at any place where it divides one section into two without creating any intersections of cutting lines.

With respect to Figs. 17 to 22 an additional step will be described for partitioning a large section of a mask into a number of smaller sections.

In Fig. 17 a conventional mask is shown with a polygon 400 and a hole representing area H. This mask corresponds with the two masks in Figs. 18a and 18b which were established with the help of the already described method. The mask of Fig. 18a has one large section 402 and the mask of Fig. 18b is provided with sections 403, 404 and 405.

For example due to different thermal extensions it is not advantageous to have large sections of physical holes in a mask, especially when the surface of each of said sections exceeds a given value. This problem is solved by the invention with the help of an additional step in which said large sections are partitioned into smaller ones.

In Fig. 19 horizontal additional cutting lines are created. For that purpose, all horizontal edges are provided with a shadow. As shown in Fig. 19, edge 410 is provided with shadow 411 and edge 416 is provided with shadow 417. Then, all vertical cutting lines which were created by the described method are provided with further shadows, too. In Fig. 19, it is the cutting line 413 which is provided with a shadow 414. All these shadows are shown in Fig. 19 with broken lines and represent that area where no additional horizontal cutting lines for partitioning said large section are allowed.

Now, horizontal cutting lines are created which do not touch any of said shadows 411, 414 and 417. These additional horizontal cutting lines have the numerals 419, 420 and 421 in Fig. 19 . Cutting line 421 is created between the shadows 414 and 417. The other two cutting lines have a predetermined distance from each other. In dependance of this distance it is also possible to create only one or more than two cutting lines between said two shadows 414 and 419.

The result of said partitioning is shown in Figs. 20a and 20b. The mask of Fig. 20a is provided with sections 423, 425, 427 and 428 where the sections 423 and 427 correspond to the sections 403 and 404 of Fig. 18b. The mask of Fig. 20b is provided with sections 424, 426 and 429 where the section 429 corresponds to the section 405 of Fig. 18b. This has the consequence that the sections 424, 425, 426 and 428 of the masks of Figs. 20a and 20b taken together represent the large section 402 of the mask of Fig. 18a. Altogether, all said sections of the masks shown in Figs. 20a and 20b correspond to the hole representing area H of the mask of Fig. 17.

In Fig. 21 vertical additional cutting lines are created. For that purpose all vertical edges and all horizontal cutting lines which were created by the aforementioned method are provided with a shadow. In Fig. 21 the edges 440 and 446 are provided with shadows 441 and 447 and the cutting lines 443 and 449 are provided with shadows 444 and 450. All shadows are shown with broken lines in Fig. 21. Between these shadows said vertical additional cutting lines are created which have the numerals 452, 453 and 454 in Fig. 21 .

The result of the described partitioning is shown in Figs. 22a and 22b where two masks are shown which have sections 456, 457, 458, 459, 460, 461 and 462. The large section 402 of Fig. 18a is divided into the section 456, 457, 459 and 461 of the mask shown in Figs. 22a and 22b. All said sections 456 to 462 summed up correspond to the hole representing area H of the mask shown in Fig. 17.

An essential requirement for replacing said conventional masks by said two masks created by the described method is that it is possible to adjust said two masks exactly in the same position when exposing a chip with said masks in succession. For that purpose, it is often necessary to provide expensive adjustment tools and methods.

According to the invention, this is avoided with the help of overlaps as shown in Figs. 23 to 25. In all these Figs. 23 to 25 a physical hole of a first mask is shown with a full line and marked with H1 and another physical hole of a second mask is shown in a broken line and marked with H2. The area in which the hole H1 and the hole H2 overlap is hatched and marked with O. This last mentioned area is called the overlap.

In Fig. 23a the holes H1 and H2 of the two masks touch each other along the line 500. An overlap does not exist. As already mentioned, if the two masks are not exactly positioned, a faulty small bridge will remain after exposure.

In Fig. 23b the hole H2 extends into the hole H1 with the effect that an overlap O is created. Due to the overlap O an inexact positioning does not cause any error.

When the two holes H1 and H2 have only a common edge but no common corner as shown for example in Fig. 23a the hole with the shorter edge is elongated for extending into the other hole. This is shown in Fig. 23b where the hole H2 is elongated and is extending into the hole H1.

In all other cases, especially when the two holes have common corners, the overlap is established under consideration that the number of inside corners created is as small as possible. Another aspect for establishing said overlap is that the necessary cutting lines are as simple as possible. This is shown in Figs. 24a, 24b and 24c in some examples.

Figure 24a shows two holes H1 and H2 which originally had one common edge 510 and two common corners 512 and 513. The overlap O is added to the hole H1 and extends into the hole H2. This could be done the other way round, too. The overlap O requires two additional edges and creates two additional inside corners extending slightly into the hole H1.

In Fig. 24b, the hole H1 is changed. The overlap O is added again to the hole H1. In this case, it could only be added to the hole H2 by creating a diagonal cutting line which is not advantageous. In both cases, one additional inside corner is created.

Figure 24c shows an example in which the hole H2 is changed. The overlap O is added to the hole H1. In this case, the addition of the overlap O to the hole H2 would cause an additional inside corner extending sharply into the hole H2.

According to another feature of the invention, the width of the overlap is determined in dependance of the length of the common edge. This is shown in Figs. 25a and 25b.

In Fig. 25a, the length of the common edge is defined by the original common cutting line which has the numeral 520 in Fig. 25a and which is the accompanying edge of the original hole H2. As this cutting line 520 is short, the original hole H2 is elongated into the hole H1 by a great amount.

In contrast to that, the original common cutting line in Fig. 25b which has the the numeral 522 is long so that the original hole H2 is elongated into the hole H1 by a small amount.

## Claims

1. Method
of splitting a layout of an electrical circuit into two complementary patterns,
said patterns being used in connection with self-supporting masks for exposing semiconductor chips,
said layout comprising edges and corners (102, 103, 104, 105) encircling a number of areas which represent either a hole (H) or no hole in said masks,
characterized by the following steps:
determining all corners (102, 103, 104, 105) of said layout which extend into said hole (H) representing areas as inside corners, all other corners of said layout which extend into said no hole representing areas being outside corners,
assigning a stability value (S) to each of said inside corners which is a function of the lengths of the adjacent edges of said inside corners,
comparing each of said stability values (S) with a stability limit function (T) which is dependant on the physical characteristics of said masks,
partitioning each of said hole (H) representing areas into sections (H′) by providing cutting lines (112, 113, 114, 115) running
from any of those inside corners with said assigned stability value (S) below said stability limit function (T) to one of said edges, and
establishing said two patterns by distributing said sections (H′) alternatively.

2. Method
according to claim 1,
wherein said step of assigning a stability value (S) to each of said inside corners comprises, in the case of a number of inside and outside corners being arranged in a row in any order whatever:
determining those two outside corners (211, 212, 213, 214) of said row which are arranged in both directions of said row adjacent to the last inside corner (204, 205, 206, 207) of said row,
establishing a new row of corners from one of said two outside corners to the other and including all outside corners of said former row, said corners of said new row being connected by hull edges (209),
repeating said steps of determining said two outside corners and establishing said new row of corners until said new row is free of inside corners, and
said hull edges and said corners of said new rows being the subject matter of assigning a stability value (S), respectively.

3. Method
according to claim 1 or 2,
wherein said step of assigning a stability value (S) to each of said inside corners comprises, in the case of one or more inside corners being arranged in a row one after the other in between two outside corners:
adding the lengths of the two adjacent edges of said inside corner to a sum (U), if only one inside corner is arranged between said two outside corners, or
adding all lengths of all adjacent edges of said inside corners to a sum (U), if a number of inside corners are arranged in a row one after the other between said two outside corners,
ascertaining the distance (L) of said two outside corners, and
dividing said distance (L) by said sum (U).

4. Method
according to claim 3,
wherein said stability limit function (T) increases, when said distance (L) of said two outside corners increases.

5. Method
according to any one of claims 1 to 4,
wherein said step of partitioning each of said hole (H) representing areas into sections (H′) comprises:
planning pairs of rectangular cutting lines (107, 108, 109, 110) running from any one of said inside corners to one of said edges, respectively,
assembling one or more sets of cutting lines which incorporate one cutting line of each of said pairs of cutting lines, respectively, and in which said cutting lines do not intersect, and
selecting that set of cutting lines (112, 113, 114, 115) which has the shortest length of all cutting lines summed up.

6. Method
according to any one of claims 1 to 5,
wherein said step of partitioning each of said hole (H) representing areas into sections (H′) comprises:
determining all sections (H′) with a surface exceeding a given value, and
partitioning each of said sections (H′) into sub-sections by providing additional cutting lines (419, 420, 421) which run between two of said cutting lines of said sections (H′) and which do not intersect any other cutting line.

7. Method
according to any one of claims 1 to 6,
wherein said step of partitioning each of said hole (H) representing areas into sections (H′) comprises:
providing an overlap (O) for each of said cutting lines, said overlap (O) expanding from one of said sections (H1), which is adjacent to said cutting line, into said other adjacent section (H2).

8. Method
according to claim 7,
wherein said step of providing an overlap (O) comprises:
determining the width of said overlap (O) as a function of the length of the accompanying cutting line.

9. Method
according to any one of claims 1 to 8,
wherein said step of establishing said two patterns comprises: determining the number of all sections (H′) or the number of sections (H′) surrounding a hole (H),
examining if said number is divisible by two and
providing an odd number of additional cutting lines if said number is not divisible by two.

## Patentansprüche

1. Verfahren
zum Aufteilen eines Layouts eines elektrischen Schaltkreises in zwei komplementäre Strukturen, wobei
die Strukturen in Verbindung mit selbsttragenden Masken zur Belichtung von Halbleiterchips verwendet werden und
das Layout Kanten und Ecken (102, 103, 104, 105) beinhaltet, die eine Anzahl von Gebieten umgeben, die entweder eine Öffnung (H) oder keine Öffnung in den Masken repräsentieren,
gekennzeichnet durch die folgenden Schritte:
Bestimmen aller Ecken (102, 103, 104, 105) des Layouts, die sich in die die Öffnung (H) repräsentierenden Gebiete hinein erstrecken, als innenseitige Ecken, während alle anderen Ecken des Layouts, die sich in die Gebiete hinein erstrecken, die keine Öffnung repräsentieren, außenseitige Ecken darstellen,
Zuordnen eines Stabilitätswertes (S) zu jeder der innenseitigen Ecken, der eine Funktion der Längen der angrenzenden Kanten der innenseitigen Ecken ist,
Vergleichen jedes Stabilitätswertes (S) mit einer Stabilitätsgrenzfunktion (T), die von den physischen Eigenschaften der Masken abhängig ist,
Aufteilen jedes der eine Öffnung (H) repräsentierenden Gebiete in Abschnitte (H′) durch Anbringen von Schnittlinien (112, 113, 114, 115), die von einer jeweiligen innenseitigen Ecke, deren zugeordneter Stabilitätswert (S) unterhalb der Stabilitätsgrenzfunktion (T) liegt, zu einer der Kanten verlaufen, und
Aufbauen der zwei Strukturen durch alternierendes Zuteilen der Abschnitte (H′).

2. Verfahren
nach Anspruch 1,
wobei der Schritt des Zuordnens eines Stabilitätswertes (S) zu jeder der innenseitigen Ecken in dem Fall, in dem eine Anzahl innenseitiger und außenseitiger Ecken in einer Reihe in irgendeiner beliebigen Reihenfolge angeordnet ist, folgendes beinhaltet:
Bestimmen jener zwei außenseitigen Ecken (211, 212, 213, 214) der Reihe, die in beiden Richtungen der Reihe an die letzte innenseitige Ecke (204, 205, 206, 207) der Reihe angrenzend angeordnet sind,
Erzeugen einer neuen Reihe von Ecken von einer der zwei außenseitigen Ecken zu der anderen, die alle außenseitigen Ecken der vorigen Reihe umfaßt, wobei die Ecken der neuen Reihe durch Hüllkanten (209) verbunden sind,
Wiederholen der Schritte zum Bestimmen der zwei außenseitigen Ecken und zum Erzeugen der neuen Reihe von Ecken, bis die neue Reihe frei von innenseitigen Ecken ist, und
wobei die Hüllkanten beziehungsweise die Ecken der neuen Reihen der Gegenstand des Zuordnens eines Stabilitätswertes (S) sind.

3. Verfahren
nach Anspruch 1 oder 2,
wobei der Schritt zum Zuordnen eines Stabilitätswertes (S) zu jeder der innenseitigen Ecken in dem Fall, in dem eine oder mehrere innenseitige Ecken in einer Reihe hintereinander zwischen zwei außenseitigen Ecken angeordnet sind, folgendes beinhaltet:
Aufaddieren der Längen der zwei angrenzenden Kanten der innenseitigen Ecke zu einer Summe (U), wenn nur eine innenseitige Ecke zwischen zwei außenseitigen Ecken angeordnet ist, oder
Aufaddieren aller Längen aller angrenzenden Kanten der innenseitigen Ecken zu einer Summe (U), wenn eine Anzahl von innenseitigen Ecken in einer Reihe hintereinander zwischen den zwei außenseitigen Ecken angeordnet ist,
Ermitteln des Abstands (L) der zwei außenseitigen Ecken und
Dividieren des Abstands (L) durch die Summe (U).

4. Verfahren
nach Anspruch 3,
wobei die Stabilitätsgrenzfunktion (T) anwächst, wenn der Abstand (L) der zwei außenseitigen Ecken zunimmt.

5. Verfahren
nach einem der Ansprüche 1 bis 4,
wobei der Schritt des Aufteilens jedes der die Öffnung (H) repräsentierenden Gebiete in Abschnitte (H′) folgendes beinhaltet:
Vorsehen von Paaren rechtwinkliger Schnittlinien (107, 108, 109, 110), die jeweils von einer beliebigen der innenseitigen Ecken zu einer der Kanten verlaufen,
Zusammenstellen eines oder mehrerer Sätze von Schnittlinien, die jeweils eine Schnittlinie von jedem der Paare von Schnittlinien enthalten und bei denen sich die Schnittlinien nicht kreuzen, und
Auswählen dasjenigen Satzes von Schnittlinien (112, 113, 114, 115), der die geringste Länge aller aufsummierten Schnittlinien aufweist.

6. Verfahren
nach einem der Ansprüche 1 bis 5,
wobei der Schritt zum Aufteilen jedes der die Öffnung (H) repräsentierenden Gebiete in Abschnitte (H′) folgendes beinhaltet:
Bestimmen aller Abschnitte (H′) mit einer Oberfläche, die einen gegebenen Wert übersteigt, und
Aufteilen jedes der Abschnitte (H′) in Unterabschnitte durch Anbringen zusätzlicher Schnittlinien (419, 420, 421), die zwischen zwei der Schnittlinien der Abschnitte (H′) verlaufen und die keine andere Schnittlinie kreuzen.

7. Verfahren
nach einem der Ansprüche 1 bis 6,
wobei der Schritt zum Aufteilen jedes der die Öffnung (H) repräsentierenden Gebiete in Abschnitte (H′) folgendes beinhaltet:
Bereitstellen einer Überlappung (O) für jede der Schnittlinien, wobei sich die Überlappung (O) von einem der Abschnitte (H1), der an die Schnittlinie angrenzt, in einen weiteren angrenzenden Abschnitt (H2) erstreckt.

8. Verfahren
nach Anspruch 7,
wobei der Schritt zum Bereitstellen einer Überlappung (O) folgendes beinhaltet:
Bestimmen der Breite der Überlappung (O) als Funktion der Länge der zugehörigen Schnittlinie.

9. Verfahren
nach einem der Ansprüche 1 bis 8,
wobei der Schritt zum Aufbauen der zwei Strukturen folgendes beinhaltet:
Bestimmen der Anzahl aller Abschnitte (H′) oder der Anzahl der Abschnitte (H′), die eine Öffnung (H) umgeben,
Prüfen, ob die Zahl durch zwei teilbar ist, und
Bereitstellen einer ungeraden Anzahl zusätzlicher Schnittlinien, wenn die Zahl nicht durch zwei teilbar ist.

## Revendications

1. Procédé
consistant à diviser une implantation de circuit électrique en deux motifs complémentaires,
lesdits motifs étant utilisés en liaison avec des masques auto-supportés à des fins d'exposition de puces à semi-conducteur,
ladite implantation comprenant des bords et des coins (102, 103, 104, 105) entourant un certain nombre de zones qui représentent soit un trou (H), soit aucun trou dans lesdits masques,
caractérisé par les étapes suivantes consistant à :
déterminer tous les coins (102, 103, 104, 105) de ladite implantation qui s'étendent dans lesdites zones représentant un trou (H) sous la forme de coins intérieurs, tous les autres coins de ladite implantation qui s'étendent dans lesdites zones ne représentant aucun trou étant des coins extérieurs,
affecter une valeur de stabilité (S) à chacun desdits coins intérieurs qui soit fonction des longueurs des bords adjacents desdits coins intérieurs,
comparer chacune desdites valeurs de stabilité (S) à une fonction de limite de stabilité (T) qui est tributaire des caractéristiques physiques desdits masques,
partager chacune desdites zones représentant un trou (H) en sections (H′) en formant des lignes de coupe (112, 113, 114, 115) s'étendant depuis l'un quelconque des coins intérieurs qui sont affectés de ladite valeur de stabilité (S) inférieure à ladite fonction de limite de stabilité (T), jusqu'à l'un desdits bords, et établir lesdits deux motifs en répartissant lesdites sections (H′) en alternance.

2. Procédé
selon la revendication 1,
dans lequel ladite étape d'affectation d'une valeur de stabilité (S) à chacun desdits coins intérieurs comprend, dans le cas où un certain nombre de coins intérieurs et extérieurs sont disposés en une rangée selon un ordre quelconque, les opérations consistant à :
déterminer deux coins extérieurs (211, 212, 213, 214) de ladite rangée qui sont disposés suivant les deux directions de ladite rangée adjacente au dernier coin intérieur (204, 205, 206, 207) de ladite rangée,
établir une nouvelle rangée de coins partant de l'un desdits deux coins extérieurs vers l'autre et comprenant tous les coins extérieurs de ladite première rangée, lesdits coins de ladite nouvelle rangée étant reliés par les bords à profil de coque (209),
répéter lesdites étapes de détermination desdits deux coins extérieurs et établir ladite nouvelle rangée de coins jusqu'à ce que ladite nouvelle rangée soit dépourvue de coins intérieurs, et
lesdits bords à profil de coque et lesdits coins desdites nouvelles rangées soumis à une affectation de valeur de stabilité (S), respectivement.

3. Procédé
selon la revendication 1 ou 2,
dans lequel ladite étape d'affectation d'une valeur de stabilité (S) à chacun desdits coins intérieurs comprend, dans le cas où un ou plusieurs coins intérieurs, sont disposés en une rangée l'un après l'autre entre deux coins extérieurs :
l'addition des longueurs des deux bords adjacents dudit coin intérieur à une somme (U), si un seul coin intérieur est disposé entre lesdits deux coins extérieurs, ou
l'addition de toutes les longueurs de tous les bords adjacents auxdits coins intérieurs à une somme (U), si un certain nombre de coins intérieurs sont disposés en une rangée l'un après l'autre entre lesdits deux coins extérieurs,
la constatation de la distance (L) desdits deux coins extérieurs, et
la division de ladite distance (L) par ladite somme (U).

4. Procédé
selon la revendication 3,
dans lequel ladite fonction de limite de stabilité (T) s'accroît lorsque s'accroît ladite distance (L) desdits deux coins extérieurs.

5. Procédé
selon l'une quelconque des revendications 1 à 4,
dans lequel ladite étape de division en sections (H′) de chacune desdites zones représentant un trou (H), comprend les opérations consistant à :
former des paires de lignes de coupe rectangulaires (107, 108, 109, 110) s'étendant respectivement depuis l'un quelconque desdits coins intérieurs jusqu'à l'un desdits bords,
assembler un ou plusieurs ensemble de lignes de coupe comprenant respectivement une ligne de coupe de chacune desdites paires de lignes de coupe, et dans lesquels lesdites lignes de coupe ne se recoupent pas, et
sélectionner l'ensemble de lignes de coupe (112, 113, 114, 115) qui présente la longueur la plus courte pour toutes les lignes de coupe additionnées.

6. Procédé
selon l'une quelconque des revendications 1 à 5,
dans lequel ladite étape de division en sections (H′) de chacune desdites zones représentant un trou (H) comprend les opérations consistant à :
déterminer toutes les sections (H′) comportant une surface qui dépasse une valeur donnée, et
diviser chacune desdites sections (H′) en sous-sections en formant des lignes de coupe supplémentaires (419, 420, 421) qui s'étendent entre deux desdites lignes de coupe desdites sections (H′) et ne recoupent aucune autre ligne de coupe.

7. Procédé
selon l'une quelconque des revendications 1 à 6,
dans lequel ladite étape de division de chacune desdites zones représentant un trou (H) en sections (H′) comprend les opérations consistant à:
former un recouvrement (O) pour chacune desdites lignes de coupe, ledit recouvrement (O) s'étendant à partir de l'une desdites sections (H1) qui est adjacente à la ligne de coupe dans ladite autre section adjacente (H2).

8. Procédé
selon la revendication 7,
dans lequel ladite étape de formation d'un recouvrement (O) comprend les opérations consistant à:
déterminer la largeur dudit recouvrement (O) en fonction de la longueur de la ligne de coupe qui lui est associée.

9. Procédé
selon l'une quelconque des revendications 1 à 8,
dans lequel ladite étape consistant à établir lesdits deux motifs comprend les opérations consistant à:
déterminer le nombre de toutes les sections (H′) ou le nombre de sections (H′) entourant un trou (H),
examiner si ledit nombre est divisible par deux et
former un nombre impair de lignes de coupe supplémentaires si ledit nombre n'est pas divisible par deux.
